Europäisches Patentamt

European Patent Office

Office européen des brevets

(19)

(11) Veröffentlichungsnummer: **0 009 220**
B1

(12)    EUROPÄISCHE PATENTSCHRIFT

(45) Veröffentlichungstag der Patentschrift:
02.03.83

(51) Int. Cl.³: **H 04 B 9/00,** G 08 C 23/00,
G 01 R 15/07

(21) Anmeldenummer: 79103445.7

(22) Anmeldetag: 14.09.79

(54) Übertragungseinrichtung zur Übertragung von Signalen über eine optische Verbindung.

(30) Priorität: 22.09.78 SE 7809961

(43) Veröffentlichungstag der Anmeldung:
02.04.80 Patentblatt 80/7

(45) Bekanntmachung des Hinweises auf die Patenterteilung:
02.03.83 Patentblatt 83/9

(84) Benannte Vertragsstaaten:
CH DE FR GB IT NL

(73) Patentinhaber· ASEA AB, S-721 83 Västeras (SE)

(72) Erfinder: Adolfsson, Morgan, Dipl.-Ing., Sigfrid Edströms gata 86, S-724 66 Västeras (SE)
Erfinder: Brogardh, Torgny, Platverksgatan 140, S-724 74 Västeras (SE)

(74) Vertreter: Boecker, Joachim, Dr.-Ing., Rathenauplatz 2-8, D-6000 Frankfurt a.M. 1 (DE)

(56) Entgegenhaltungen:
DE-A-2 708 606
DE-A-2 716 788
DE-B-1 221 725
FR-A-2 361 022
US-A-3 619 612
US-A-3 772 514
US-A-4 032 843
US-A-4 070 572
BULLETIN DE L'ASSOCIATION SUISSE DES ELECTRICIENS, Band 68, Nr. 6, 19. März 1977, Seiten 268—274 Zürich, CH. S. C. KITSOPOULOS: »Elements of Light-Wave Communications over Fiberguides«
CONFERENCE ON LASER AND ELECTROOPTI-CAL SYSTEMS, 7.—9. Februar 1978 OSA/IEEE, Seiten 18, 19 San Diego Washington, U. S. A. B. G. PHILLIPS et al.: »A 650 MHz fiber optic commandable analog communication system«

## Übertragungseinrichtung zur Übertragung von Signalen über eine optische Verbindung

Die Erfindung betrifft eine Übertragungseinrichtung zur Übertragung von Signalen über eine optische Verbindung. Bei den zu übertragenden Signalen kann es sich um die Ausgangssignale von Meßgeräten handeln. Eine solche Übertragungseinrichtung ist bekannt aus der US-A-3 913 001.

Es ist bekannt, daß Meßsignale und andere Signale über eine optische Verbindung übertragen werden können. Eine solche Verbindung besteht aus einem Lichtsender, lichtübertragenden Gliedern und lichtmessenden Gliedern. Der Lichtsender enthält in geeigneter Weise Glieder zur Modulation des ausgesandten Lichtes, so daß das ausgesandte Licht eine Information über den Istwert des Meßsignals enthält. Das lichtübertragende Glied, das aus einem Lichtleiter (optische Faser) bestehen kann, überträgt das Lichtsignal auf das lichtmessende Glied, wo die Information über das Meßsignal in ein geeignetes Signal, beispielsweise in eine dem Meßsignal proportionale elektrische Spannung umgewandelt wird. Ein Meßgerät dieser Art hat mehrere Vorteile. Man erhält automatisch eine galvanische Trennung zwischen Sender und Empfänger, die somit auf ganz verschiedenen Potentialen liegen können. Ferner ist die optische Verbindung, im Gegensatz zu elektrischen Signalleitungen, gegenüber Störungen durch magnetische Felder vollkommen unempfindlich. Ein weiterer Vorteil gegenüber elektrischen Verbindungen besteht darin, daß bei einer optischen Verbindung keine Funken oder Kurzschlüsse auftreten können, was beispielsweise in explosionsgefährdeter Umgebung von großer Bedeutung ist.

Bei einer aus der US-A-3 772 514 bekannten Übertragungsanordnung wird auf der Senderseite eine galvanische Rückführung zum Vergleichsglied verwendet, um Linearität und Stabilität des Ausgangssignals zu erreichen. Eine Voraussetzung bei der bekannten Anordnung besteht darin, daß die im Sender vorhandene Rückführungsschleife einen optischen Leiter, eine Fotodiode und einen Verstärker enthält, die identisch mit den entsprechenden Gliedern zum und im Empfängerteil sind. Die Rückführung erfolgt von derselben Lichtquelle, von der auch zum Empfänger hin gesendet wird. Ein Nachteil der bekannten Anordnung besteht darin, daß auf der Senderseite viel Energie erforderlich ist, wenn die Übertragung eine hohe Dynamik aufweisen soll.

Bei der aus der US-A-3 913 001 bekannten Übertragungseinrichtung wird das vom Sender zum Empfänger zu übertragende Signal im Sender in eine Wechselstromgröße übergeführt, über die optische Verbindung übertragen und im Empfänger gleichgerichtet und von einem Verstärker verstärkt. Das über die zweite optische Verbindung vom Empfänger zum Sender übertragene Rückführungssignal ist ein in Abhängigkeit der Ausgangsgröße des Verstärkers im Empfänger gewonnenes impulsbreitenmoduliertes Signal. Dieses wird im Sender von einem Verstärker demoduliert. Sowohl für die Übertragung des Meßsignals vom Sender zum Empfänger als auch für die Demodulierung des Rückführungssignals im Sender sind relativ hohe Leistungen erforderlich, wenn die Übertragungseinrichtung mit großer Genauigkeit, großer Dynamik und großer Bandbreite arbeiten soll.

Bei einer Übertragungseinrichtung der hier behandelten Art ist es häufig sehr wichtig, den Leistungsverbrauch im Sender möglichst klein zu halten, da die Energieversorgung des Senders bei größerem Energiebedarf häufig sehr kompliziert und kostspielig ist, beispielsweise dann, wenn der Sender auf einem hohen elektrischen Potential liegt. Diese Schwierigkeiten bei der Energieversorgung macht die digitale Übertragung der Übertragungsgröße über die optische Verbindung weniger attraktiv, da eine solche Übertragung normalerweise Analog-Digitalwandler und Lichtmodulatoren auf der Senderseite erfordern, die viel Leistung verbrauchen.

Bei einer konventionellen analogen Übertragung wird die Übertragungsgröße jedoch von der Verstärkung bzw. Dämpfung der optischen Verbindung beeinflußt. Die Verstärkung bzw. die Dämpfung können aus verschiedenen Gründen variieren. So variiert die Dämpfung eines Lichtleiters u. a. mit Änderungen seines Krümmungsradius, und die Verstärkung der lichtaussendenden und lichtmessenden Glieder (Leuchtdioden, Fotodioden) variiert mit der Temperatur und der Zeit (Alterung). Dies hat zur Folge, daß die Verstärkung der Meßeinrichtung variieren kann, wodurch die Genauigkeit des Ausgangssignals der Übertragungseinrichtung beeinträchtigt wird.

Ein anderer Nachteil bei einer konventionellen analogen Übertragung besteht — wie bereits angedeutet - darin, daß ihr dynamischer Bereich klein ist, wenn die zur Verfügung stehende Leistung auf der Senderseite gering ist.

Der Erfindung liegt die Aufgabe zugrunde, eine Übertragungseinrichtung der eingangs genannten Art zu entwickeln, bei welcher der Sender einen sehr kleinen Leistungsverbrauch hat und die Einrichtung gleichzeitig eine große Genauigkeit, große Dynamik und große Bandbreite aufweist.

Zur Lösung dieser Aufgabe wird eine Übertragungseinrichtung nach dem Oberbegriff des Anspruches 1 vorgeschlagen, welche erfindungsgemäß die im kennzeichnenden Teil des Anspruches 1 genannten Merkmale hat.

Vorteilhafte Weiterbildungen der Erfindung sind in den Unteransprüchen genannt.

Gemäß einer bevorzugten Ausführungsform ist die Übertragungseinrichtung nach der Erfindung mit vorzugsweise auf der Empfängerseite angeordneten Gliedern zur Steuerung der Verstärkung (oder Dämpfung) versehen, welche die Verstärkung derart steuern, daß die Gesamtverstärkung zwischen Regler und Vergleichsglied konstant gehalten wird. Dies kann mit Hilfe besonderer Kalibrierungssignale geschehen, welche mit dem Übertragungssignal entweder zeitmultiplext oder frequenzmultiplext übertragen werden können. Auf diese Weise kann die Verstärkung der Übertragungseinrichtung mit großer Genauigkeit konstant gehalten werden.

Der außerordentlich geringe Leistungsbedarf der Übertragungseinrichtung nach der Erfindung auf der Senderseite ermöglicht es, daß die Energieversorgung des Senders gemäß einer bevorzugten Ausführungsform der Erfindung mittels optischer Übertragungsmittel geschieht, was für viele Anwendungsmöglichkeiten der Übertragungseinrichtung nach der Erfindung von großem Vorteil ist.

Anhand der in den Figuren gezeigten Ausführungsbeispiele soll die Erfindung näher erläutert werden. Es zeigt

Fig. 1 eine Übertragungseinrichtung gemäß der Erfindung mit zeitmultiplexer Kalibrierung,

Fig. 2 eine Übertragungseinrichtung gemäß der Erfindung mit frequenzmultiplexer Kalibrierung,

Fig. 3 eine Ausführungsform der Übertragung mit bipolaren Vergleichssignalen,

Fig. 4 eine alternative Ausführungsform zur Kompensation von Dämpfungsänderungen in dem Lichtleiter, der das Rückführungssignal überträgt.

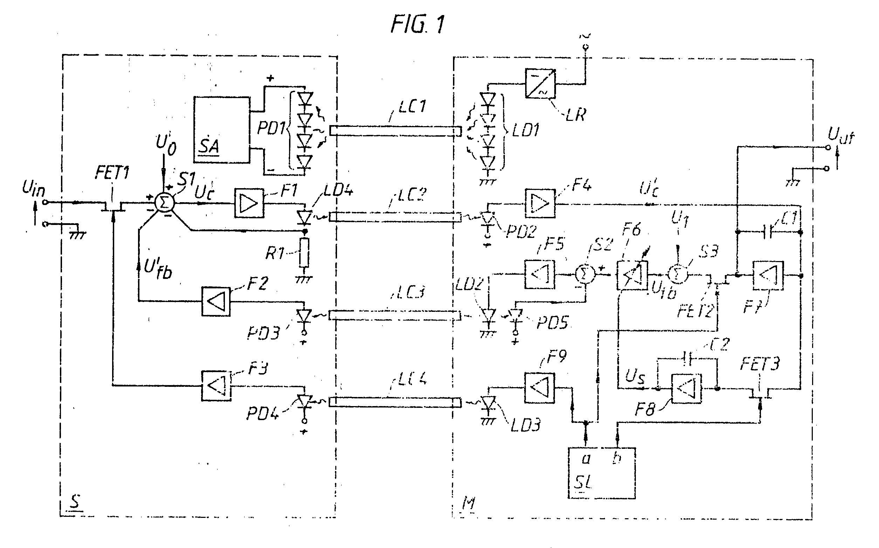

Fig. 1 zeigt eine Übertragungseinrichtung nach der Erfindung zur Übertragung eines Signals, welches dem Sender als analoges elektrisches Eingangssignal $U_{in}$ zugeführt wird und am Ausgang des Empfängers als analoges elektrisches Ausgangssignal $U_{ut}$ abgegeben wird. Die Übertragungseinrichtung besteht aus dem Sender S und dem Empfänger M, die über vier Lichtleiter LC1—LC4 miteinander verbunden sind. Zwischen Sender und Empfänger kann eine Entfernung liegen, die beispiesweise von einigen Metern bis zu mehreren Kilometern oder mehr betragen kann. Sender und Empfänger können auch auf verschiedenen elektrischen Potentialen liegen, wobei die Übertragungseinrichtung beispielsweise einen Strommeßwert von einer Hochspannungsleitung (Sender) auf Erdpotential (Empfänger) übertragen kann. Alternativ, wenn beispielsweise nur ein kleiner Potentialunterschied von der Übertragungseinrichtung zu überbrücken ist, können Sender und Empfänger in Anschluß aneinander angeordnet sein, wobei die Lichtleiter mit zugenhörigen Leucht- und Fotodioden aus optoelektronischen Kopplungselementen bestehen können.

Die Einrichtung arbeitet nach dem Kompensationsprinzip. Ein vergleichendes Glied, das Summierungsglied S1 im Sender, vergleicht das Eingangssignal $U_{in}$ mit einem Rückführungssignal $U'_{fb}$. Das Differenzsignal $U_c$ zwischen diesen beiden Signalen wird auf den Empfänger übertragen und steuert dort einen Regler F7, C1. Das Ausgangssignal des Reglers ist das Ausgangssignal der Übertragungseinrichtung , und das Rückführungssignal ist eine lineare Funktion dieses Signals. Der Regler arbeitet, bis das genannte Differenzsignal Null wird, wobei das Ausgangssignal $U_{ut}$ der Übertragungseinrichtung dem Eingangssignal $U_{in}$ proportional sein wird.

Das Eingangssignal $U_{in}$ der Übertragungseinrichtung wird dem Summierungsglied S1 über einen Feldeffekttransistor FET1 zugefürt. Dieser wird von einer Steuerlogik SL im Empfänger gesteuert. Im Summierungsglied S1 wird das Eingangssignal $U_{in}$ mit dem Rückführungssignal $U'_{fb}$ verglichen, und das Differenzsignal $U_c$ steuert über einen Verstärker F1 den Strom durch eine Leuchtdiode LD4. In Reihe mit der Leuchtdiode liegt ein Widerstand R1. Die Spannung am Widerstand ist ein Maß für den durch die Leuchtdiode fließenden Strom und wird mit entgegengesetztem Vorzeichen zum Summierungsglied S1 zurückgeführt. Hierdurch erreicht man eine Proportionalität zwischen dem Differenzsignal $U_c$ des Summierungsgliedes und dem Strom der Leuchtdiode, was eine gute Genauigkeit in dem in der Nähe von Null liegenden Bereich ergibt, wo das Differenzsignal $U_c$ des Summierungsgliedes und damit der Diodenstrom beim Betrieb der Übertragungseinrichtung liegen werden. Über den Lichtleiter LC2, eine Fotodiode PD2 und einen Verstärker F4 wird das Differenzsignal $U_c$ auf den Empfänger übertragen, wo es mit $U'_c$ bezeichnet ist. Dieses Signal wird einem Regler (der Verstärker F7 und der Kondensator C1) mit integrierender Charakteristik zugeführt. Das Ausgangssignal des Reglers ist das Ausgangssignal $U_{ut}$ der Übertragungseinrichtung. Dieses Signal wird über einen Feldeffekttransistor FET2 und ein Summierungsglied S3 einem Verstärker F6 mit steuerbarer Verstärkung zugeführt. Das Ausgangssignal des Verstärkers wird dem Summierungsglied S1 des Senders zugeführt, und zwar über ein Summierungsglied S2, einen Verstärker F5, eine Leuchtdiode LD2, den Lichtleiter LC3, eine Fotodiode PD3 und einen Verstärker F2 (dessen Ausgangssignal mit $U'_{fb}$ bezeichnet ist). Das Licht von der Leuchtdiode LD2 wird auch einer Fotodiode PD5 zugeführt; die von derselben Art ist wie die Fotodiode PD3. Das Ausgangssignal von der Fotodiode PD5 wird dem Summierungsglied S2 mit entgegengesetztem Vorzeichen zugeführt. Hierdurch erhält man eine linearisierende Rückführung, aufgrund welcher das Ausgangssignal von der Diode PD3 eine lineare Funktion des Signals $U_{fb}$ wird, unabhängig von Variationen (z. B. aufgrund von Temperaturänderungen, Alterung usw.) der Charakteristik der Leuchtdiode LD2.

Zur Steuerung der Verstärkung des Verstärkers F6 wird das Differenzsignal $U'_c$ über einen Feldeffekttransistor FET3 einem zweiten Regler, dem Verstärker F8 mit dem Rückführungskondensator C2, mit integrierender Charakteristik

zugeführt. Das Ausgangssignal $U_s$ des Reglers wird dem Verstärker F6 zugeführt und steuert dessen Verstärkung.

Die Feldeffekttransistoren FET1, FET2 und FET3 arbeiten als Schaltglieder und werden von der Steuerlogik SL gesteuert. Hierbei kann es sich z. B. um einen astabilen Multivibrator (oder einen anderen Typ von Oszillatr) handeln, der wechselweise Signale an den beiden Ausgängen a und b abgibt. Die Signale von den Ausgängen a und b werden den Feldeffekttransistoren FEt2 und FET3 zugeführt. Das Signal vom Ausgang a wird dem Feldeffekttransistor FET1 über einen Verstärker F9, eine Leuchtdiode LD3, einen Lichtleiter LC4, eine Fotodiode PD4 und einen Verstärker F3 zugeführt. Wenn ein Signal am Ausgang a abgegeben wird, werden die Feldeffekttransistoren FET1 und FET2 leitend. Während dieses Intervalls, dem Übertragungsintervall, stellt sich der Regler F7, C1 so ein, daß zwischen dem Ausgangssignal $U_{ut}$ und dem Eingangssignal $U_{in}$ Proportionalität herrscht. Der Feldeffekttransistor FET3 ist während dieses Intervalls nichtleitend, d. h. das Ausgangssignal des Reglers F8, C2 und damit die Verstärkung des Verstärkers F6 werden konstant gehalten. Während des nächsten Intervalls, dem Kalibrierungsintervall, erscheint ein Ausgangssignal am Ausgang b der Steuerlogik wodurch der Feldeffekttransistor FET3 leitend wird, während die Feldeffekttransistoren FET1 und FET2 nichtleitend werden. Hierbei wird das Eingangssignal $U_{in}$ vom Summierungsglied S1 fortgeschaltet, und das Differenzsignal $U'_c$ wird an den Eingang des Reglers F8, C2 angeschlossen, wobei die Verstärkung des Verstärkers F6 in der nachstehend beschriebenen Weise justiert wird. Da anzunehmen ist, daß Verstärkungsveränderungen in der optischen Verbindung LD2, LC3, PD3 langsam stattfinden, können die Übertragungsintervalle, falls gewünscht, im Vergleich zu den dazwischenliegenden Kalibrierungsintervallen lang gemacht werden. Man kann sich auch verfeinertere Methoden vorstellen, bei denen der Zeitabstand zwischen den Kalibrierungsintervallen beispielsweise davon abhängig gemacht wird, wie schnell die Übertragungscharakteristik zwischen den Summierungsgliedern S2 und S3 variiert, und die Länge des Kalibrierungsintervalls davon abhängig gemacht wird, wie schnell sich der Regler F8, C2 einstellt, wobei eine adaptive, kontinuierliche Steuerung der Steuerlogik SL mit Hilfe der Ausgangssignale der Regler F7, C1 und F8, C2 vorgenommen wird.

Während der Kalibrierungsintervalle werden den Summierungsgliedern S1 und S3 nur die beiden genau konstantgehaltenen Bezugsspannungen $U_0$ und $U_1$ zugeführt. Diese kann man von geeigneten Bezugsspannungsgebern, wie z. B. temperaturkompensierten Zenerdioden, erhalten. Dem Regler F8, C2 wird das Differenzsignal $U'_c$ zugeführt, das dem Differenzsignal $U_c$ und somit der Differenz zwischen $U_0$ und dem Rückführungssignal $U'_{fb}$ proportional ist. Der Regler erreicht einen stationären Zustand, wenn $U_c = U'_c = 0$ ist. D. h. wenn $U_0 = U'_{fb}$. Es gilt $U'_{fb} = F \cdot U_1$, wobei F die Verstärkung bzw. Dämpfung auf der Übertragungs-Verbindung für das Rückführungssignal zwischen den Summierungsgliedern S3 und S1 ist. Wenn sich der Regler eingestellt hat, ist daher $U_0 = F \cdot U_1$, d. h. die Verstärkung in der genannten Übertragungs-Verbindung ist $F = \dfrac{U_0}{U_1}$. Während der Kalibrierungsintervalle wird also die Verstärkung des Verstärkers F6 so eingestellt, daß die gesamte Verstärkung des Rückführungssignals immer auf dem obengenannten konstanten, von dem Bezugsspannungen genau bestimmten Wert gehalten wird.

Während des Übertragungsintervalls sind die Feldeffekttransistoren FET1 und FET 2 leitend, und der Feldeffekttransistor FET3 ist nichtleitend. Das Ausgangssignal $U_s$ des Reglers F8, C2 und damit die Verstärkung des Verstärkers F6 sind daher konstant und gleich dem während des unmittelbar vorangegangenen Kalibrierungsintervalls eingestellten Wert. Während dieses Intervalls arbeitet der Regler F7, C1, bis sein Eingangssignal und damit das Vergleichssignal $U_c/U'_c$ Null wird. Es gilt dann

$$U_{in} + U_0 - U'_{fb} = 0$$

Ferner gilt

$$U'_{fb} = F \cdot (U_1 + U_{ut})$$

und

$$F = \frac{U_0}{U_1}$$

Daraus folgt

$$U_{in} + U_0 = \frac{U_0}{U_1} (U_1 + U_{ut}),$$

d. h.

$$U_{ut} = \frac{U_1}{U_0} \cdot U_{in}$$

Die Verstärkung

$$\frac{U_{ut}}{U_{in}}$$

der Übertragungseinrichtung wird auf diese Weise genau konstant gehalten, unabhängig von Verstärkungsvariationen in den zugehörigen optischen Übertragungen.

Die Übertragung LD4, LC2, PD2 vom Sender zum Empfänger arbeitet nur als Nullpunktdetektor. Die Leuchtdiode LD4 kann daher einen sehr kleinen dynamischen Bereich und damit eine sehr kleine Leistung haben. Das einzige, was von dieser Übertragung gefordert wird, ist, daß sie einen definierten Nullpunkt hat, was man leicht mit Hilfe der vorstehend beschriebenen Stromrückführung R1, S1 erreichen kann.

Im übrigen besteht der Sender aus passiven Bauelementen (PD3, PD4) sowie aus den Verstärkern F1, F2, F3, die als sehr leistungssparende Glieder ausgeführt werden können. Auf den Verstärker F3 kann außerdem verzichtet werden, wenn das Glied FET1 ein Fotofeldeffekttransistor ist, und die Funktion des Verstärkers F2 kann vom Verstärker F1 übernommen werden, wenn der Fotodiodenstrom von der Leuchtdiode PD3 direkt als Eingangssignal auf das Summierungsglied S1 gegeben wird. Der Leistungsbedarf des Senders ist daher bei einem Übertragungsgerät nach der Erfindung sehr niedrig, und zwar so niedrig, daß die erforderliche Energie auf optischem Wege zu dem Sender übertragen werden kann. Ein Beispiel für eine solche optische Energieübertragung ist in Fig. 1 gezeigt. Ein Gleichrichter oder Verstärker LR speist mehrere reihengeschaltete Leuchtdioden LD1. Über einen oder mehrere Lichtleiter LC1 wird das ausgesandte Licht zu dem Sender übertragen, wo es von den reihengeschalteten Fotodioden PD1 in elektrische Energie umgewandelt wird, die einem Stromversorgungsglied SA zur Speisung der Bauelemente des Senders zugeführt wird. Durch die Reihenschaltung einer geeigneten Anzahl Fotodioden PD1 kann man die gewünschte Versorgungsspannung erreichen. -

Die Forderung nach hoher Dynamik und der damit erforderliche hohe Leistungsbedarf ist bei einem Übertragungsgerät nach der Erfindung von der Leuchtdiode (LD4) des Senders auf die Leuchtdiode LD2 des Empfängers verlegt worden. Der Empfänger im allgemeinen auf Erdpotential oder an einer anderen Stelle, an der die Energieversorgung keine Probleme bereitet. Der stark reduzierte Leistungsbedarf im Sender bringt im allgemeinen sehr große Vorteile mit sich.

Die Dynamik der Übertragungseinrichtung wird von der Dynamik der Rückführungsverbindung LD2, LC3, PD3 bestimmt. Da die Leistungsversorgung der Leuchtdiode LD2 keine Schwierigkeiten bereitet, kann die Dynamik der Übertragungseinrichtung hoch sein.

Die Genauigkeit der Übertragungseinrichtung wird auch dadurch bestimmt, wie exakt die Verstärkung in der Rückführungsverbindung konstant gehalten werden kann. Durch das vorstehend beschriebene automatische Kalibrierungsverfahren kann die Verstärkung der Rückführungsverbindung sehr konstant gehalten werden, und somit kann eine sehr hohe Genauigkeit eines Übertragungsgerätes nach der Erfindung erreicht werden.

Für gewisse Anwendungen ist die Verstärkung der Rückführungsverbindung ausreichend konstant, ohne von dem beschriebenen Kalibrierungsverfahren Gebrauch machen zu müssen, so daß in diesen Fällen die hierfür erforderlichen Bauteile fortgelassen werden können.

Der Regler F7, C1 behält sein Ausgangssignal während der Kalibrierungsintervalle praktisch unverändert bei, insbesondere dann, wenn ein weiterer Feldeffekttransistor FET vorgesehen wird, um das Eingangssignal von F7 während des Kalibrierungsintervalles fortzuschalten. Ein erneuter Einschwingverlauf zu Beginn eines jeden Übertragungsintervalls ist daher nicht erforderlich, was eine größere obere Grenzfrequenz für die Übertragungsverbindung ergibt und einfachere Glieder zur Verarbeitung des Ausgangssignals der Übertragungsverbindung ermöglicht.

Die Regler F7, C1 und F8, C2 sind in Fig. 1 als Regler mit einer reinen integrierenden Charakteristik dargestellt. Alternativ können die Regler beispielsweise eine proportional-integrierende Charakteristik haben.

Das Eingangssignal $U_{in}$ der Übertragungseinrichtung erhält man im Normalfall von irgendeinem Geber. In Fig. 1 ist angenommen, daß der Geber eine elektrische Spannung an die Übertragungseinrichtung gibt, doch kann man sich auch andere Arten von Eingangssignalen für die Übertragungseinrichtung vorstellen.

Die Übertragungsverbindung LD3, LC4, PD4 von der Steuerlogik SL zum Feldeffekttransistor FET1 kann in bestimmten Fällen entfallen, wenn man sowohl auf der Sender- als auch auf der Empfängerseite Zugang zu irgendeinem gemeinsamen Taktgeber, z. B. die Netzwechselspannung, zur Steuerung der Umschaltung zwischen den Übertragungs- und Kalibrierungsintervallen hat.

Genauso kann die Energieversorgung des Senders in gewissen Fällen auf andere als der in Fig. 1 gezeigten Weise geschehen, wobei die Übertragungsverbindung LD1, LC1, PD1 fortfallen kann.

Falls gewünscht, kann eine Übertragungseinrichtung nach Fig. 1 zur Übertragung von mehreren Meßsignalen verwendet werden. Sender und Empfänger werden dann mit Schaltergliedern versehen welche die einzelnen Eingangssignale der Reihe nach zum Summierungsglied S1 führen und im gleichen Takt die Ausgangsspannung des Reglers F7, C1 zwischen entsprechenden Ausgängen von der Übertragungseinrichtung umschalten.

Die vorstehend benutzten Begriffe »Lichtleiter«, »lichterfassendes Glied« usw. beziehen sich auf Glieder, die mit elektromagnetischer Strahlung sowohl im Bereich des sichtbaren Lichtes wie in den angrenzenden Wellenlängenbereichen arbeiten. -

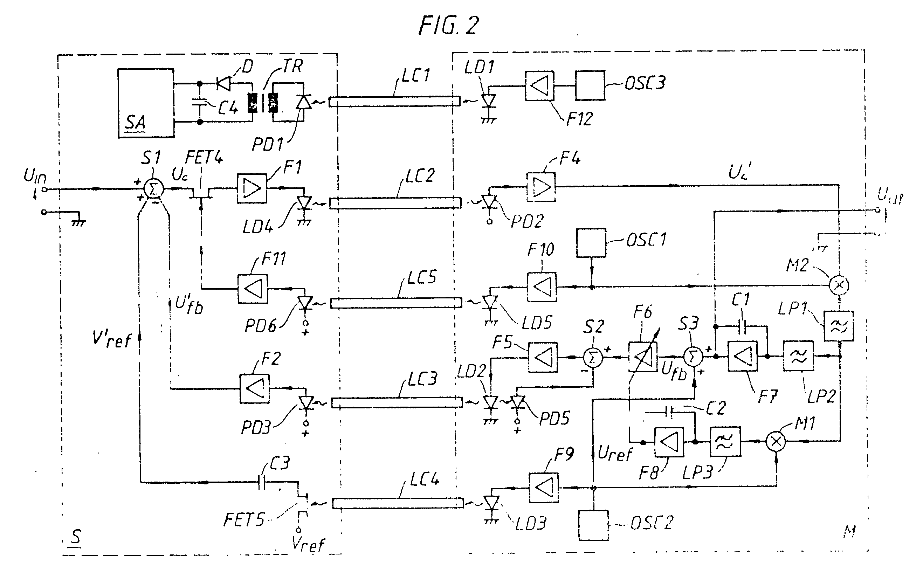

Fig. 1 zeigt eine Übertragungseinrichtung nach der Erfindung, bei der die Übertragung und Kalibrierung abwechselnd zeitlich hintereinander erfolgt, weshalb man von einer zeitmultiplexen Durchführung dieser beiden Vorgänge sprechen kann. Fig. 2 zeigt eine alternative Ausführung, bei der die Übertragungs- und Kalibrierungssignale gleichzeitig übertragen werden, jedoch verschiedene Frequenzen haben, weshalb man von einer frequenzmultiplexen Durchführung der Übertragung und Kalibrierung sprechen kann.

Auf dieselbe Weise wie in Fig. 1 wird das Eingangssignal $U_{in}$ mit dem Rückführungssignal $U'_{fb}$ im Summierungsglied S1 verglichen. Das Ergebnis, das Differenzsignal $U_c$, wird über die Verbindung LD4, LC2, PD2 zum Empfänger übertragen, wo es den Regler F7, C1 steuert, dessen Ausgangssignal das Ausgangssignal $U_{ut}$ des Übertragungsgerätes ist. Über den Verstärker F6 mit steuerbarer Verstärkung sowie die Verbindung LD2, LC3, PD3 wird das Rückführungssignal zu dem Sender übertragen. Ein zweiter Regler F8, C2 steuert die Verstärkung des Verstärkers F6 derart, daß die gesamte Verstärkung des Rückführungssignals zwischen den Summierungsgliedern S3 und S1 konstant bleibt. Die prinzipielle Wirkungsweise ist somit dieselbe wie bei der Übertragungseinrichtung nach Fig. 1.

Die Übertragungsverbindung für das Differenzsignal ist »zerhackerstabilisiert«. Von einem Oszillator OSC1, der mit einer im Verhältnis zu den übrigen in die Übertragungseinrichtung vorkommenden Frequenzen hohen Frequenz $f_1$ arbeitet, erhält man eine Impulsfolge mit der Frequenz $f_1$. Diese wird über einen Verstärker F10 und die Verbindung LD5, LC5, PD6 zum Sender übertragen, wo sie über einen Verstärker F11 den Feldeffekttransistor FET4 steuert. Der Transistor zerhackt das Differenzsignal mit der Frequenz $f_1$, und das auf diese Weise zerhackte Signal wird über die Verbindung LD4, LC2, PD2 und einen Verstärker F4 auf einen Demodulator M2 übertragen, der ein Multiplikationsglied sein kann. Der Demodulator wird vom Ausgangssignal des Oszillators OSC1 gesteuert und gibt ein Gleichspannungssignal ab, das der Komponente mit der Frequenz $f_1$ im Ausgangssignal des Verstärkers F4 entsprcht. Dieses Signal wird einem Tiefpaßfilter LP1 zugeführt, welcher die hochfrequente Demodulations-Oberschwingung herausfiltert. Auf diese Weise erhält man eine sichere Anzeige des Nullniveaus des Differenzsignal $U_c$, und zwar unabhängig von Veränderungen in den Nullniveaus der zugehörenden Bauteile, beispielsweise aufgrund des Dunkelstroms der Fotodiode PD2.

Die Kalibrierung der Rückführungsverbindung S3, S1 geschieht mit Hilfe einer Impulsfolge mit einer Frequenz $f_0$, die niedriger als $f_1$, jedoch höher als die obere Grenzfrequenz des Differenzsignals $U_c$ ist. Der Oszillator OSC2 liefert diese Impulsfolge mit der Frequenz $f_0$ und einer genau konstantgehaltenen Amplitude $U_{ref}$, die dem Summierungsglied S3 zugeführt wird. Das Ausgangssignal vom Oszollator steuert über die Leuchtdiode LD3 und den Lichtleiter LC4 den Fotofeldeffekttransistor FET5. Dieser Transistor moduliert eine Bezugsgleichspannung $V_{ref}$, und die Wechselspannungskomponente $V'_{ref}$ des modulierten Signals wird über einen Sperrkondensator C3 zum Summierungsglied S1 geleitet. Im Differenzsignal $U_c$ ist daher eine Komponente mit der Frequenz $f_0$ vorhanden, die über die »zerhackerstabilsierte« Verbindung FET4, F1, LD4, LC2, PD2, F4, M2, LP1 einem Demodulator M1 zugeführt wird, der vom Ausgangssignal des Oszillators OSC2 gesteuert wird. Die Demodulations-Oberschwingung wird im Tiefpaßfilter LP3 entfernt, dessen Ausgangssignal eine Gleichspannung mit einer Amplitude ist, die der Amplitude der Komponente mit der Frequenz $f_0$ im Differenzsignal entspricht. Das Rückführungssignal $U'_{fb}$ zum Summierungsglied S1 wird eine Komponente $U'_{ref}$ mit der Frequenz $f_0$ enthalten. Der Regler F8, C2 wird die Verstärkung des Verstärkers F6 so regeln, daß das Eingangssignal des Reglers Null wird, also $U'_{ref} = V'_{ref}$ wird. Da jedoch $U'_{ref} = F \cdot U_{ref}$ ist, wobei F die Verstärkung in der Rückführungsverbindung zwischen S3 und S1 ist, und da $V'_{ref} = \text{konst} \cdot V_{ref}$ ist, wird

$$F = \text{konst} \; \frac{V_{ref}}{U_{ref}}.$$

Die Verstärkung der Rückführungsverbindung wird also automatisch auf einem konstanten, von den beiden Bezugsspannungen bestimmten Wert gehalten.

Das Eingangssignal $U_{in}$ wird im Summierungsglied S1 mit dem Rückführungssignal $U'_{fb}$ verglichen, und die niederfrequente Komponente im Vergleichssignal $U'_c$ wird über ein Tiefpaßfilter LP2, dessen Grenzfrequenz niedriger als $f_0$ und $f_1$ liegt, zum Regler F7, C1 geführt. Der Regler bewirkt, daß seine Ausgangsspannung $U_{ut}$ der Bedingung $U_{ut} \cdot F = U_{in}$ genügt, d. h. die Verstärkung

$$\frac{U_{ut}}{U_{in}} = \frac{U_{ref}}{\text{konst} \cdot V_{ref}}$$

des Übertragungsgerätes wird konstant, unabhängig von beispielsweise Veränderungen in der Verstärkung der optischen Verbindung LD2, LC3, PD3.

Statt die Ausgangssignale der Oszillatoren OSC1 und OSC2 zum Sender zu übertragen, können im Sender separate Oszillatoren angeordnet werden. Diese Oszillatoren werden dann ebenso wie die Oszillatoren OSC1 und OSC2 vorzugsweise kristallgesteuert, damit die Oszillatoren paarweise dieselbe Frequenz halten. Es können dann jedoch keine Demodulatoren M1 und M2 verwendet werden, sondern es werden stattdessen Bandpaßfilter und Gleichrichterkreise zur Demodulation verwendet.

Die Übertragung von Energie zum Sender geschieht wie in Fig. 1 über eine optische Verbindung, die jedoch etwas anders ausgeführt ist. Ein Oszillator OSC3 erzeugt eine gepulste Gleichspannung, die nach Verstärkung in einem Verstärker F12 eine Leuchtdiode LD1, z. B. einen Halbleiterlaser, speist, deren Licht über einen Lichtleiter LC1 einer Fotodiode PD1 zugeführt wird. Die Wechselspannungskomponente in der Ausgangsgröße der Fotodiode wird von einem Transformator TR auf eine geeignete Spannungshöhe transformiert und dann von einem Spitzenwertgleichrichter, der aus einer Diode D und einem Kondensator C4 besteht, gleichgerichtet und den Stromversorgungsgliedern SA für die Bauteile des Senders zugeführt.

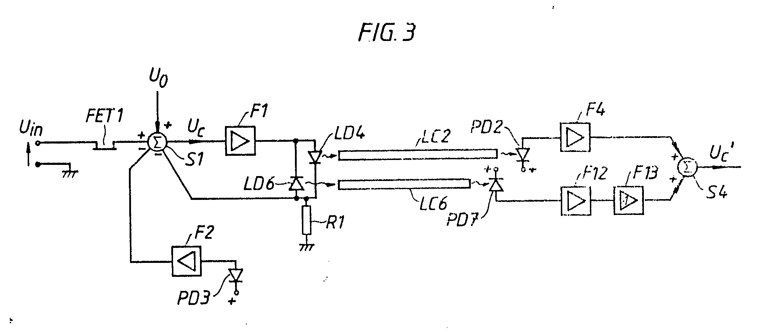

Fig. 3 zeigt eine alternative Ausführungsart der Übertragungsverbindung für das Differenzsignal $U_c$. Zur Leuchtdiode LD4 ist in Fig. 3 eine Leuchtdiode LD6 antiparallelgeschaltet, deren Lichtsignal über einen Lichtleiter LC6 einer Fotodiode PD7 zugeführt wird. Das Ausgangssignal dieser Fotodiode wird im Verstärker F12 verstärkt, dessen Ausgangssignal über einen vorzeichenumkehrenden Verstärker F13 zusammen mit dem Ausgangssignal des Verstärkers F4 einem Summierungsglied S4 zugeführt wird. Ein positives Differenzsignal $U_c$ wird über die Strecke F1, LD4, LC2, PD2, F4, S4 übertragen, während ein negatives Differenzsignal über F1, LD6, LC6, PD7, F12, F13, S4 übertragen wird. Es kann also sowohl das positive wie das negative Differenzsignal übertragen werden, wodurch das System bessere Regeleigenschaften bekommt.

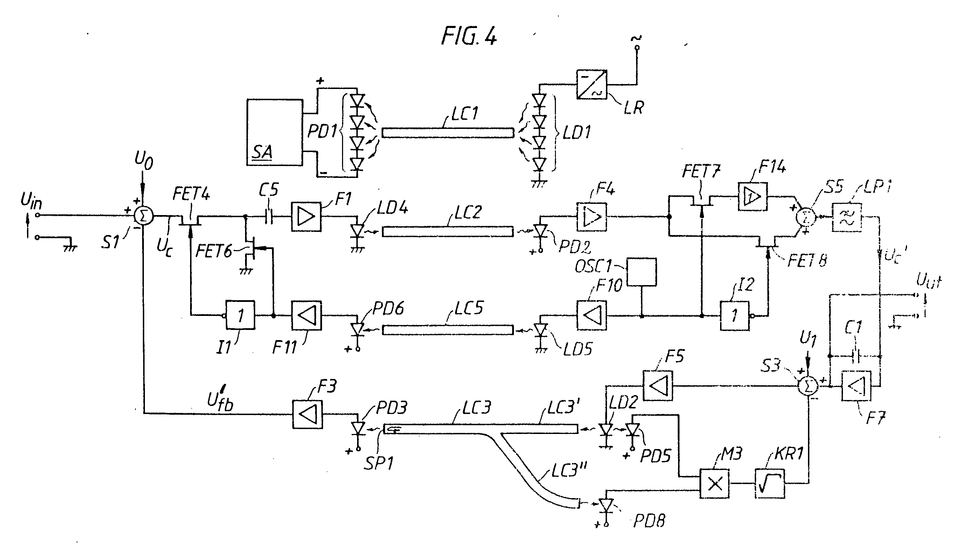

In den Anordnungen nach den Fig. 1 bzw. 2 wird ein zeit- beziehungsweise frequenzmultiplexes Kalibrierungssignal verwendet, um die Dämpfungsänderungen in der Übertragungsverbindung für das Rückführungssignal zu kompensieren. Fig. 4 zeigt eine alternative Möglichkeit zur Kompensation der Dämpfungsänderungen in dem zu dieser Verbindung gehörenden Lichtleiter. Das Eingangssignal $U_{in}$ wird dem Summierungsglied S1 zugeführt, wo es mit dem Rückführungssignal $U'_{fb}$ verglichen wird. Das Differenzsignal $U_c$ wird über einen Feldeffekttransistor FET4 und einen Kondensator C5 dem Verstärker F1 und der Leuchtdiode LD4 zugeführt, deren Ausgangssignal über den Lichtleiter LC2 und die Fotodiode PD2 dem Verstärker F4 zugeführt wird. Das Ausgangssignal dieses Verstärkers wird einem Summierungsglied S5 einerseits über einen Feldeffekttransistor FET7 und einen Vorzeichenumkehrer F14 und andererseits über einen Feldeffekttransistor FET8 zugeführt. Das Ausgangssignal des Summierungsgliedes wird über das Tiefpaßfilter LP1 dem Regler F7, C1 zugeführt, dessen Ausgangssignal, wie in Fig. 1 und Fig. 2, das Ausgangssignal $U_{ut}$ der Übertragungseinrichtung ist.

Die Übertragungsverbindung für das Rückführungssignal besteht aus dem Verstärker F5, der Leuchtdiode LD2, dem Lichtleiter LC3, der Fotodiode PD3 und dem Verstärker F3, dessen Ausgangssignal das Rückführungssignal $U'_{fb}$ ist.

Der Lichtleiter LC3 ist an seinem dem Sender zugewandten Ende mit einem halbreflektierenden Spiegel SP1 versehen, der einen Teil des Lichtes zum Empfänger zurückreflektiert. Am Empfänger ist der Lichtleiter in zwei Zweige, LC3' und LC3", aufgeteilt. Von dem im Verzweigungspunkt ankommenden, reflektierten Licht geht ein Teil über den Zweig LC3" zur Fotodiode PD8, deren Ausgangssignal einem Multiplikator M3 zugeführt wird. Einem anderen Eingang des Multiplikators wird ein Signal zugeführt, welches der Intensität des von der Leuchtdiode LD2 ausgestrahlten Lichtes proportional ist und mit Hilfe einer Fotodiode PD5 erzeugt wird. Das Ausgangssignal des Multiplikators wird einem die Quadratwurzel bildenden Glied KR1 zugeführt, dessen Ausgangssignal im Summierungsglied S3 vom Ausgangssignal $U_{ut}$ subtrahiert wird.

Den Summierungsgliedern S1 und S3 werden die Bezugsspannungen $U_0$ bzw. $U_1$ zugeführt, die eine wechselnde Polarität der Eingangs- und Ausgangssignale $U_{in}$ und $U_{ut}$ ermöglichen, obgleich das Rückführungssignal $U'_{fb}$ nur eine Polarität haben kann.

Der Oszillator OSC1 steuert über den Verstärker F10, die Leuchtdiode LD5, den Lichtleiter LC5, die Fotodiode PD6, den Verstärker F11 und den Vorzeichenumkehrer I1 den Feldeffekttransistor FET4, der das Differenzsignal $U_c$ zerhackt. Während der nichtleitenden Intervalle von FET4 wird das Signal von einem vom Verstärker F11 gesteuerten Feldeffekttransistor FET6 an Erde kurzgeschlossen. Die Wechselspannungskomponente des zerhackten Differenzsignals wird zum Empfänger übertragen (die Gleichstromkomponente wird vom Kondensator C5 gesperrt). Die Komponenten FET7, FET8, F14, I2 und S5 bilden einen phasengesteuerten Gleichrichter, der das Vergleichssignal $U'_c$ zurückbildet.

Das aus den Bauteilen LR, LD1, LC1, PD1, SA bestehende Speiseglied stimmt mit dem in Fig. 1 gezeigten Speiseglied überein.

Wenn das von der Leuchtdiode LD2 in den Lichtleiter LC3 eingeleitete Licht die Intensität $I_1$ hat, so erhält man am senderseitigen Ende des Lichtleiters Licht mit der Intensität $I_2$, wobei $I_2$ proportional $K \cdot I_1$ ist und K der Dämpfungsfaktor des Lichtleiters ist. Aus dem rechten Ende des Lichtleiters LC3" erhält man die Lichtintensität $I_3$, die $K^2 \cdot I_1$ proportional ist. Dem Multiplikator M3 wird also einerseits über die Fotodiode PD8 ein $K^2 \cdot I_1$ proportionales Signal und andererseits über die Fotodiode PD5 ein $I_1$ proportionales Signal zugeführt. Das Ausgangssignal des Multiplikators entspricht daher $K^2 \cdot I_1^2$, und das quadratwurzelbildende Glied KR1 liefert ein Signal, das $K \cdot I_1$ entspricht. Der Verstärker F5 hat eine hohe Verstärkung und steuert die Lichtintensität der Leuchtdiode LD2 auf solche Weise, daß $K \cdot I_1$ immer dem Ausgangssignal $U_{ut}$ proportional ist. Da die Intensität des auf die Fotodiode PD3 geleiteten Lichtes $K \cdot I_1$ proportional ist, wird $U'_{fb}$ proportional $U_{ut}$ sein, und zwar unabhängig von Veränderungen des Dämpfungsfaktors des Lichtleiters.

Die in den vorstehend beschriebenen Ausführungsbeispielen der Erfindung verwendeten Leucht- und Fotodioden können selbstverständlich auch durch andere Bauelemente zum Aussenden oder Erfassen elektromagnetischer Strahlung ersetzt werden. Die Lichtleiter LC1—LC5 können, beispielsweise bei einem kurzen Abstand zwischen Sender und Empfänger, fortgelassen oder beispielsweise durch ein Linsensystem ersetzt werden. Dieses kann zum Beispiel dann vorteilhaft sein, wenn der Sender auf einem Objekt sitzt, das im Verhältnis zum Empfänger beweglich ist. Entsprechend einer anderen Alternative können mehrere der Signale über denselben Lichtleiter übertragen werden, indem man beispielsweise Licht mit verschiedenen Wellenlängen oder frequenzmoduliertes Licht mit unterschiedlichen Modulationsfrequenzen für die einzelnen Signale verwendet. In den vorstehend beschriebenen Ausführungsbeispielen wird für den Vergleich das Differenzsignal $U_c$ zwischen dem Eingangssignal $U_{in}$ und dem Rückführungssignal $U'_{fb}$ gebildet. Alternativ kann der Vergleich beispielsweise durch Bildung des Quotienten zwischen den beiden Signalen oder auf andere Weise vorgenommen werden.

**Patentansprüche**

1. Übertragungseinrichtung zur Übertragung von Signalen über eine optische Verbindung, bestehend aus einem Sender (S) und einem Empfänger (M) an den Enden der optischen Verbindung, mit einem im Sender (S) vorhandenen Vergleichsglied (S1), welches das Eingangssignal ($U_{in}$) des Senders (S) mit einem Rückführungssignal ($U'_{fb}$) vom Empfänger vergleicht, mit Gliedern (LD4, LC2, PD2) zur Übertragung eines vom Vergleichsglied (S1) gelieferten Vergleichssignals ($U_c$) über eine erste optische Verbindung (LC2) zum Empfänger (M), mit einem Verstärker (F7) im Empfänger (M), an dessen Eingang das Vergleichssignal ($U'_c$) geführt ist und dessen Ausgangssignal ($U_{ut}$) ein Maß für das zu übertragende Signal ist, und mit einer zweiten optischen Verbindung (LC3) zwischen Empfänger (M) und Sender (S), welche in der Rückführungsschleife für das Rückführungssignal ($U'_{fb}$) liegt, wobei die Eingangsgröße der Rückführungsschleife das Ausgangssignal ($U_{ut}$) des Empfängers (M) ist, dadurch gekennzeichnet, daß der genannte Verstärker (F7) im Empfänger als Regler (F7, C1) mit wenigstens teilweiser integraler Charakteristik ausgebildet ist und daß die Intensität des über die zweite optische Verbindung (LC3) übertragenen Lichtsignals ein direktes Maß für das Rückführungssignal ($U'_{fb}$) ist.

2. Übertragungseinrichtung nach Anspruch 1, dadurch gekennzeichnet, daß zur Kalibrierung der Übertragungsverbindung (F6, S2, F5, LD2, LC3, PD3, F2) für das vom Regler (F7, C1) gelieferte Rückführungssignal ($U'_{fb}$) dieses Signal dem Vergleichsglied (S1) über einen Verstärker (F6) mit steuerbarer Verstärkung zugeführt wird, und daß die Übertragungseinrichtung ein Glied (F8, C2) enthält, welches die genannte Verstärkung derart steuert, daß die gesamte Verstärkung des Rückführungssignals ($U'_{fb}$) zwischen dem Regler (F7, C1) und dem Vergleichsglied (S1) auf einem vorbestimmten, konstanten Wert gehalten wird.

3. Übertragungseinrichtung nach Anspruch 2, dadurch gekennzeichnet, daß im Empfänger (M) der Übertragungsverbindung für das Rückführungssignal ($U'_{fb}$) ein erstes Kalibrierungssignal ($U_1$) bekannter Größe einem Vergleichsglied (S3) zugeführt wird, welches zum Sender (S) übertragen wird und dort in einem Vergleichsglied (S1) mit einem zweiten Kalibrierungssignal ($U_0$) bekannter Größe verglichen wird, und daß Glieder zur Übertragung des Vergleichsergebnisses ($U_c$) auf das Glied (F8, C2) zur Steuerung der Verstärkung des steuerbaren Verstärkers (F6) vorhanden sind.

4. Übertragungseinrichtung nach Anspruch 3, dadurch gekennzeichnet, daß bei zeitlich begrenzten Kalibrierungsintervallen im Empfänger (M) nur das erste Kalibrierungssignal ($U_1$) der Übertragungsverbindung für das Rückführungssignal ($U'_{fb}$) zugeführt wird und daß im Sender (S) nur das zweite Kalibrierungssignal ($U_0$) und das Rückführungssignal ($U'_{fb}$) dem Vergleichsglied (S1) zugeführt werden.

5. Übertragungseinrichtung nach Anspruch 3, dadurch gekennzeichnet, daß die Kalibrierungssignale ($U_{ref}$, $V'_{ref}$) periodisch variierende Signale sind, welche der Übertragungsverbindung für das Rückführungssignal ($U'_{fb}$) und den Vergleichsgliedern (S1, S3) zusammen mit den Meßsignalen zugeführt werden.

6. Übertragungseinrichtung nach einem der vorhergehenden Ansprüche, dadurch gekennzeichnet, daß die optische Verbindung (LC2) im Sender (S) eine stromrückgeführte Leuchtdiode, (LD4, R1, F1) zur Übertragung des Vergleichssignals ($U'_c$) enthält.

7. Übertragungseinrichtung nach einem der Ansprüche 1—5, dadurch gekennzeichnet, daß die optische Verbindung (LC3) im Empfänger (M) eine optisch rückgeführte Leuchtdiode (LD2, PD5, F5) zur Übertragung des Rückführungssignals ($U'_{fb}$) enthält.

8. Übertragungseinrichtung nach einem der vorhergehenden Ansprüche, dadurch gekennzeichnet, daß Glieder (LD1, LC1, PD1) zur optischen Übertragung von Energie zum Sender (S) zur Speisung der elektrischen Glieder des Senders (S) vorhanden sind.

9. Übertragungseinrichtung nach einem der vorhergehenden Ansprüche, dadurch gekennzeichnet, daß die Glieder zur Übertragung des Vergeichssignals ($U'_c$) zwei parallele Übertragungskanäle (LD4, LC2, PD2, F4 bzw. LD6, LC6, PD7, F12, F13) enthalten, wobei der eine Kanal positive und der andere Kanal negative Werte des Vergleichssignals ($U'_c$) überträgt.

10. Übertragungseinrichtung nach Anspruch 1, bei dem die Übertragungsverbindung für das Rückführungssignal ($U_{fb}$) lichtaussendende Glieder, einen Lichtleiter und lichtmessende Glieder enthält, dadurch gekennzeichnet, daß der Lichtleiter (LC3) an seinem den lichtmessenden Gliedern zugewandten Ende mit partiell reflektierenden Organen (SP1) und an seinem den lichtaussendenden Gliedern zugewandten Ende mit Gliedern (LC3'', PD8) zur Intensitätsmessung des reflektierten Lichtes versehen ist und daß Glieder vorhanden sind, welche die lichtaussendenden Glieder (LD2) derart steuern, daß Änderungen der Dämpfung des Lichtleiters (LC3) kompensiert werden.

11. Übertragungseinrichtung nach einem der vorhergehenden Ansprüche, dadurch gekennzeichnet, daß die Übertragungsverbindung für das Vergleichssignal (U'c) mit Gliedern (FET4) zur Modulation des Signals im Sender (S) und mit Gliedern (M2) zur Demodulation des Signals im Empfänger (M) versehen ist.

**Claims**

1. System for transmitting signals over an optical link, consisting of a transmitter (S) and a receiver (M) at the ends of the optical link and comprising a comparator (S1) on the transmitter side comparing the input signal ($U_{in}$) of the transmitter (S) with a feedback signal ($U'_{fb}$) from the receiver, means (LD4, LC2, PD2) for transmitting a comparison signal ($U_c$) supplied from the comparator (S1) to the receiver (M) via a first optical link (LC2), an amplifier (F7) on the transmitter side (M) the input of which is the comparison signal ($U'_c$) and the output signal ($U_{ut}$) of which is a measure for the signal to be transmitted, and a second optical link (LC3) between transmitter (S) and receiver (M), which link forms part of the feedback loop for the feedback signal ($U'_{fb}$), whereby the input signal of the feedback loop is the output signal ($U_{ut}$) of the receiver (M), characterized in that said amplifier (F7) on the receiver side is designed as a regulator (F7, C1) with at least a partly integral characteristic, and that the intensity of the light signal transmitted via the second optical link (LC3) is a direct measure for the feedback signal ($U'_{fb}$).

2. Transmitting system according to claim 1, characterized in that for calibrating the transmission link (F6, S2, F5, LD2, LC3, PD3, F2) for the feedback signal ($U'_{fb}$) supplied from said rgulator (F7, C1) said signal is fed to the comparator (S1) via an controllable amplifier (F6), and that the transmitting system includes means (F8, C2) controlling said amplification such that the entire amplification of the feedback signal ($U'_{fb}$) between said regulator (F7, C1) and said comparator (S1) is kept constant at a predetermined value.

3. Transmitting system according to claim 2, characterized in that on the receiver side (M) a first calibrating signal ($U_1$) of a known magnitude is supplied to the transmission link for the feedback signal ($U'_{fb}$) via a comparator (S3), that said first calibrating signal is transmitted to the transmitter (S) and there compared in a comparator (S1) with a second calibrating signal ($U_0$) of a known magnitude, and that means are provided for transmitting the result ($U_c$) of the comparison to a circuit (F8, C2) for controlling the amplification of the controllable amplifier (F6).

4. Transmitting system according to claim 3, characterized in that in the event of calibrating intervals limited in time in the receiver (M) only the first calibrating signal ($U_1$) is fed into the transmission link for the feedback signal ($U'_{fb}$) and that in the transmitter (S) only the second calibrating signal ($U_0$) and the feedback signal ($U'_{fb}$) is fed to the comparator (S1).

5. Transmitting system according to claim 3, characterized in that the calibrating signals ($U_{ref}$, $V'_{ref}$) are periodically varying signals, wich are fed into the transmission link for the feedback signal ($U'_{fb}$) and to the comparators (S1, S3) along with the measurement signals.

6. Transmitting system according to any of the preceding claims, characterized in that the optical link (LC2) comprises on the transmitter side a light emitting diode (LD4) with current feedback means (R1, F1) for transmitting the comparison signal ($U'_c$).

7. Transmitting system according to any of the preceding claims 1 to 5, characterized in that the optical link (LC3) comprises in the receiver (M) a light emitting diode (LD2) with optical feedback means (PD5, F5) for transmitting the feedback signal ($U'_{fb}$).

8. Transmitting system according to any of the preceding claims, characterized in that means (LD1, LC1, PD1) are provided for optically transmitting power to the transmitter (S) for energizing the electrical components of the transmitter.

9. Transmitting system according to any of the preceding claims, characterized in that the means for the transmission of the comparison signal ($U'_c$ include two parallel transmission channels (LD4, LC2, PD2, F4 and LD6, LC6, PD7, F12, F13 respectively), one of these channels transmitting positive values of the comparison signal ($U'_c$) and the other channel transmitting negative values of the comparison signal.

10. Transmitting system according to claim 1, wherein the transmission link for the feedback signal ($U'_{fb}$) includes light emitting means, a light conductor, and light detecting means, characterized in that the light conductor (LC3) is provided on its end facing the light detecting means with partially reflecting elements (SP1) and on its end facing the light emitting means with elements (LC3'', PD8) for sensing the intensity of the reflected light, and that means are provided which control the light emitting means (LD2) such that variations in the attenuation of the light conductor (LC3) are compensated.

11. Transmitting system according to any of the preceding claims, characterized in that the transmission link for the comparison signal ($U'_c$) is provided with means (FET4) for modulating the signal on the transmitter side (S) and with means (M2) for demodulating the comparison signal on the receiver side (M).

**Revendications**

1. Système de la transmission de signaux par l'intermédiaire d'une liaison optique constitué par un émetteur (S) et par un récepteur (M) aux extrémités de la liaison optique, avec un comparateur (S1) qui compare le signal d'entrée (U$_{in}$) de l'émetteur (S) avec un signal de réaction (U'$_{fb}$) du récepteur, avec des éléments (LD4, LC2, PD2) servant à transmettre par une première liaison optique (LC2) au récepteur (M) un signal de comparaison (U$_c$) fourni par le comparateur (S1) qui est présent dans l'émetteur, avec un amplificateur (F7) dans le récepteur (M), à l'entrée duquel est amené le signal de comparaison (U'$_c$) et dont le signal de sortie (U$_{ut}$) est une mesure pour le signal à transmettre. et avec une seconde liaison optique (LC3) entre le récepteur (M) et l'émetteur (S) et située dans la boucle de réaction pour le signal de réaction (U'$_{fb}$), la grandeur d'entrée dans la boucle de réaction étant le signal de sortie (U$_{ut}$) du récepteur (M), caractérisé par le fait que ledit amplificateur (F7) dans le récepteur est réalisé sous la forme d'un régulateur (F7, C1) à caractéristique au moins partiellement intégrale, et que l'intensité du signal lumineux transmis par l'intermédiaire de la seconde liaison optique (LC3) est une mesure directe pour le signal de réaction (U'$_{fb}$).

2. Sysème de transmission selon la revendication 1, caractérisé par le fait que pour le calibrage de la liaison de transmission (F6, S2, F5, LD2, LC3, PD3, F2) pour le signal de réaction (U'$_{fb}$) fourni par le régulateur (F7, C1), ce signal est appliqué au comparateur (S1) par un amplificateur (F6) à amplification réglable, et que le système de transmission comporte un élément (F8, C2) qui commande de telle façon ladite amplification, que l'amplification totale du signal de réaction (U'$_{fb}$) entre le régulation (F7, C1) et le comparateur (S1) est maintenue à une valeur constante prédéterminée.

3. Système de transmission selon la revendication 2, caractérisé par le fait que dans le récepteur (M) on applique à la liaison de transmission pour le signal de réaction (U'$_{fb}$), par l'intermédiaire d'un comparateur (S3), un premier signal de calibrage (U$_1$) de grandeur connue, signal de calibrage qui est transmis à l'émetteur (S) et y est comparé dans un comparateur (S1) avec un second signal de calibrage (U$_0$) de grandeur connue, et que des éléments sont prévus pour transmettre le résultat de la comparaison (U$_c$) à l'élément (F8, C2) pour la commande de l'amplification de l'amplificateur (F6) susceptible d'être commandée.

4. Système de transmission selon la revendication 3, caractérisé par le fait que dans le cas d'intervalles de calibrage limités dans le temps dans le récepteur (M), seul le premier signal de calibrage (U$_1$) est appliqué à la liaison de transmission pour le signal de réaction (U''$_{fb}$) et que dans l'émetteur (S) seul le second signal de calibrage (U$_0$) et le signal de renvoi (U'$_{fb}$) sont appliqués au comparateur (S1).

5. Système de transmission selon la revendication 3, caractérisé par le fait que les signaux de calibrage (U$_{ref}$, V'$_{ref}$) sont des signaux variant périodiquement, et qui sont appliqués, avec les signaux de mesure, à la liaison de transmission p·: le signal de réaction (U'$_{fb}$) et aux comparateurs (S1, S3).

6. Système de transmission selon l'une des revendication$_r$ précédentes, caractérisé par le fait que la liaison optique (LC2) dans l'émetteur (F) contient une diode luminescente (LD4, R1, F1) à récupération de courant pour la transmission du signal de comparaison (U'$_c$).

7. Système de transmission selon l'une des revendications 1—5, caractérisé par le fait que la liaison optique (LC3) dans le récepteur (M), comporte une diode luminescente (LD2, PD5, F5) à récupération optique pour la transmission du signal de réaction (U'$_{fb}$).

8. Système de transmission selon l'une des revendications présédentes, caractérisé par le fait qu'il est prévu des éléments (LD1, LC1, PD1) pour la transmission optique d'une énergie à l'émetteur (S) en vue d'alin.unter les éléments électriques de l'émetteur (S).

9. Système de transmission selon l'une des revendications précédentes, caractérisé par le fait que les éléments pour la transmission du signal de comparaison (U'$_c$) comportent deux canaux parallèles de transmission (LD4, LC2, PD2, F4 et LD6, LC6, PD7, F12, F13), l'un des canaux transmettant des valeurs positives du signal de comparaison (U'$_c$) et l'autre canal des valeurs négatives du signal de comparaison (U'$_c$).

10. Système de transmission selon la revendication 1, dans lequel la liaison de trasmission pour le signal de réac.on (U'$_{fb}$) comporte des éléments émettant de la lumière, un guide d'ondes de lumière et des éléments qui mesurent la lumière, caractérisé par le fait que le guide d'ondes de lumière (LC3) est pourvu à son extrémité, qui est voisine des éléments servant à mesurer la lumière, avec des organes partiellement réfléchissant (SP1) et à son extrémité qui est voisine des éléments émettant la lumière, avec des éléments (LC3'', PD8) pour la mesure de l'intensité de la lumière· réfléchie, et qu'il est prévu des éléments qui commandent de telle façon les éléments émettant la lumière (LD2) que des modifications de l'atténuation du guide d'ondes de lumière (LC3) sont compensées.

11. Système de transmission selon l'une des revendications précédentes, caractérisé par le fait que la liaison de transmission pour le signal de co| paraison (U'$_c$) est pourvued'éléments (FET4) pour moduler le signal (S) et d'éléments (M2) pour moduler le signal dans le récepteur (M).

FIG. 1

0 009 220

FIG. 2

FIG. 3

FIG. 4